# FASCICULE DE BREVET EUROPEEN

(11) **EP 0 534 866 B1**
(45) Date de publication et mention de la délivrance du brevet: **08.01.1997**
(21) Numéro de dépôt: 92420279.9
(22) Date de dépôt: 17.08.1992
(51) Int. Cl.: H03K 17/56, H03K 17/60

(54) **Interrupteur statique à faibles pertes**
Statischer Schalter mit geringen Verlusten
Low-loss static switch

(30) Priorité: 27.08.1991 FR 9110896
(43) Date de publication de la demande: 31.03.1993
(73) Titulaire: CROUZET Automatismes, F-26000 Valence (FR); AEROSPATIALE Société Nationale Industrielle, 75781 Paris Cédex 16 (FR)
(72) Inventeur: Revillet, Georges, F-26120 Barcelonne (FR); Berge, Philippe, F-31770 Colomiers (FR)
(74) Mandataire: de Beaumont, Michel

(56) Documents cités:
- DE-A- 4 005 168
- PATENT ABSTRACTS OF JAPAN vol. 11, no. 294 (E-544)(2741) 22 Septembre 1987;& JP-A-62094020
- TRANSACTIONS OF THE INSTITUTE OF ELECTRONICS AND COMMUNICATION vol. E69, no. 4, Avril 1986, TOKYO JP pages 509 - 511 OHASHI ET AL 'A switching circuit composed of BJT and MOS-FET'

## Description

La présente invention concerne le domaine des interrupteurs statiques et plus particulièrement des interrupteurs statiques à faibles pertes.

Les interrupteurs statiques couramment utilisés comprennent les transistors bipolaires, les transistors MOS de puissance et les transistors IGBT (du terme anglo-saxon signifiant "transistor bipolaire à grille isolée").

Il est généralement admis que c'est le transistor bipolaire fonctionnant en régime de saturation qui présente les plus faibles pertes à l'état passant. En effet, un transistor MOS présente à l'état passant les caractéristiques d'une résistance entre le drain et la source. Par conséquent, les pertes de puissance entre drain et source sont proportionnelles au carré du courant de drain et deviennent importantes pour des forts courants. Par contre un transistor bipolaire saturé, c'est-à-dire dont le courant de base est supérieur au courant de collecteur divisé par le gain du transistor, présente une chute de tension (Vce) entre collecteur et émetteur pratiquement constante et de valeur faible (de l'ordre de 0,3V à 0,5V). De même les transistors IGBT présentent une chute de tension Vce entre collecteur et émetteur pratiquement constante mais plus élevée que celle d'un transistor bipolaire (de l'ordre du volt).

Toutefois, les transistors bipolaires capables de véhiculer des courants importants ont généralement un faible gain et nécessitent un important courant de base pour devenir saturés. Ainsi, l'avantage de la faible dissipation de puissance entre collecteur et émetteur est contrebalancé par l'inconvénient de pertes de puissance non négligeables dans le circuit de commande de la base. Par contre la commande des transistors de type IGBT ou MOS se fait sur une grille capacitive et la puissance nécessaire à leur commande est négligeable.

Si l'on prévoit un transistor bipolaire pour qu'il puisse commuter un courant maximal déterminé, son circuit de commande de base sera dimensionné pour fournir un courant saturant le transistor lorsqu'il est traversé par ce courant maximal. Comme on l'a mentionné précédemment, ce courant de base est relativement important et il continue généralement à être fourni au transistor quand le courant à commuter devient faible. Ainsi, la puissance nécessaire à la commande du transistor lorsqu'il est traversé par un courant plus faible que prévu est inutilement grande et le rendement du transistor devient mauvais.

Un objet de la présente invention est de réaliser un interrupteur statique présentant des pertes à l'état passant aussi faibles que possible sur une grande plage de courants.

La présente invention vise plus particulièrement un interrupteur statique susceptible de fonctionner pour la commutation de courants situés dans une première plage étendue de valeurs et susceptible en outre de fonctionner occasionellement au delà de cette plage.

Cet objet est atteint grâce à un interrupteur statique comprenant au moins un transistor bipolaire dont la base est commandée à travers un amplificateur par un signal de commande un capteur mesurant le courant traversant l'interrupteur ; au moins un transistor bipolaire à grille isolée (IGBT) connecté en parallèle sur ledit au moins un transistor bipolaire, dont la grille est commandée par ledit signal de commande ; et des moyens pour couper la commande de la base dudit au moins un transistor bipolaire lorsque le courant traversant l'interrupteur est inférieur à une valeur prédéterminée.

Selon un mode de réalisation de la présente invention, lesdits moyens sont pilotés par un comparateur du courant traversant l'interrupteur à ladite valeur prédéterminée.

Selon un mode de réalisation de la présente invention, ledit amplificateur est prévu pour fournir un courant de base au transistor bipolaire adapté à le mettre en régime de saturation jusqu'à un courant maximal déterminé et en ce que ladite valeur prédéterminée est choisie égale au courant pour lequel la puissance dissipée par le transistor bipolaire est égale à la puissance dissipée par le transistor IGBT.

Selon un mode de réalisation de la présente invention, l'interrupteur statique comprend un deuxième comparateur comparant le courant traversant l'interrupteur à une deuxième valeur prédéterminée, associé à des moyens coupant la commande desdits transistors si le courant est supérieur à la deuxième valeur prédéterminée.

Selon un mode de réalisation de la présente invention, l'interrupteur statique comprend un troisième comparateur comparant le courant traversant l'interrupteur à une troisième valeur prédéterminée, associé à des moyens coupant la commande desdits transistors lorsque le courant reste supérieur à la troisième valeur prédéterminée pendant une durée plus longue qu'une durée prédéterminé.

Selon un mode de réalisation de la présente invention, des moyens sont prévus pour mémoriser le nombre de coupures consécutives de la commande desdits transistors et pour couper définitivement leur commande si ce nombre est supérieur à un nombre prédéterminé.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 illustre des diagrammes de puissance perdue en fonction des courants commutés pour différents types d'interrupteurs statiques ;
la figure 2 illustre un mode de réalisation d'un interrupteur statique selon la présente invention ;
la figure 3 illustre l'interrupteur statique de la figure 2 associé à des circuits de protection ; et
la figure 4 illustre un mode de réalisation d'un dispositif de mémorisation utilisé dans les circuits de protection de la figure 3.

La présente invention se base sur une analyse des pertes de divers types d'interrupteurs statiques dans divers régimes de fonctionnement.

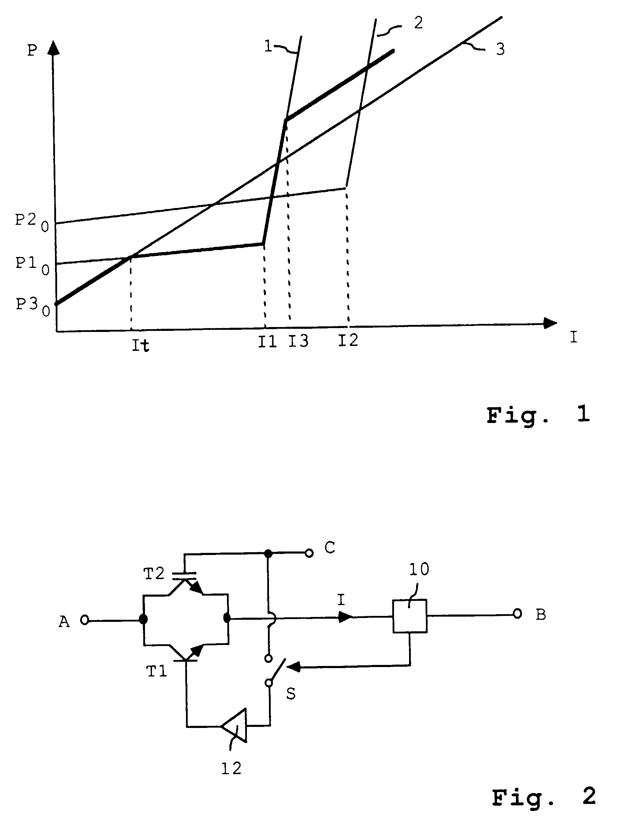

La figure 1 illustre les allures de la puissance perdue par un transistor bipolaire et par un transistor IGBT en fonction du courant I commuté. Cette puissance perdue P est la somme de la puissance dissipée entre les bornes principales du transistor et de la puissance de commande du transistor.

La courbe 1 correspond à un transistor bipolaire prévu pour être saturé en dessous d'un courant maximal I₁. Pour des courants I variant entre 0 et I₁, la puissance P croît régulièrement à partir d'une valeur initiale P1₀. Cette valeur P1₀ correspond sensiblement à la puissance du circuit de commande de base prévu pour saturer le transistor bipolaire quand il est traversé par le courant I₁. Si le courant I croît au-delà de I₁, la puissance P croît très rapidement. Ceci est dû au fait que le transistor bipolaire rentre dans un régime de fonctionnement linéaire où sa tension collecteur-émetteur Vce se met à croître.

La courbe 2 illustre la puissance dissipée par un transistor bipolaire dont le circuit de commande de base est prévu pour obtenir un régime de saturation jusqu'à un courant maximal I₂ supérieur à I₁. La puissance dissipée par le circuit de commande a une valeur P2₀. Cette courbe est obtenue à partir de la précédente par translation vers le haut de la quantité P2₀-P1₀ et vers la droite de la quantité I2-I1.

La courbe 3, correspondant à un transistor IGBT, ne dépend pas du courant maximal que l'on veut commuter pourvu qu'une tension suffisamment élevée soit appliquée à sa grille. La puissance P croît régulièrement à partir d'une puissance faible P3₀ qui est la puissance dissipée pour alimenter le circuit de commande.

En analysant les courbes de la figure 1, la demanderesse a constaté que, quel que soit le courant maximal à commuter, le transistor bipolaire présente les plus faibles pertes pour des courants compris entre un courant de transition It et ce courant maximal. Par contre, le transistor IGBT est plus avantageux pour des courants I inférieurs à It. La demanderesse en a déduit qu'il serait intéressant, pour un courant maximal I₁ choisi, de concevoir un interrupteur statique ayant les caractéristiques d'un transistor IGBT pour des courants à commuter inférieurs à It, et d'un transistor bipolaire pour des courants supérieurs à It.

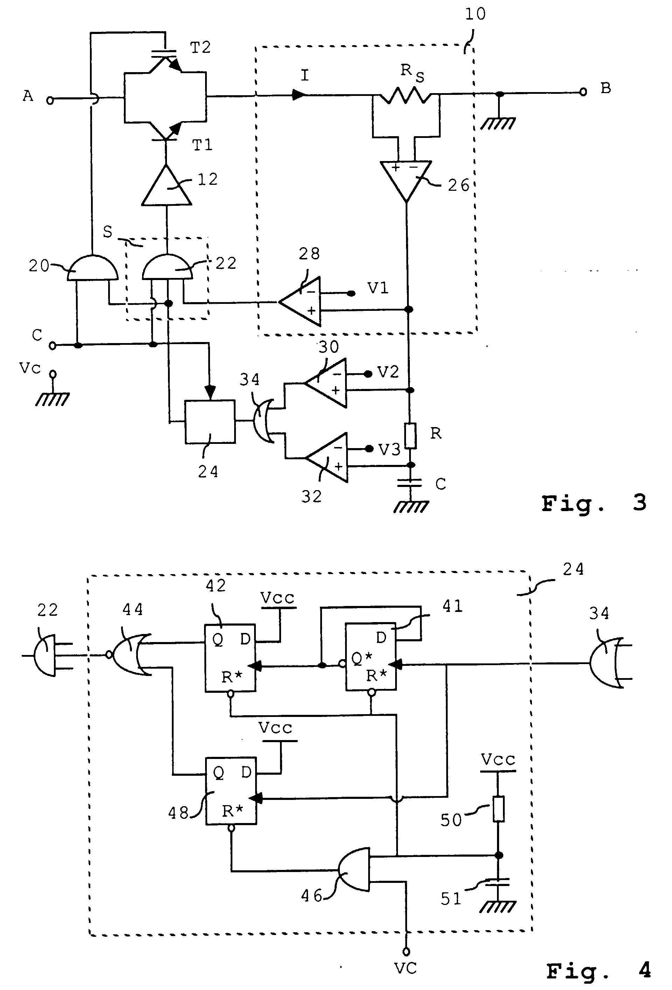

La figure 2 représente un mode de réalisation d'un interrupteur selon la présente invention ayant ces caractéristiques. L'interrupteur comprend un transistor bipolaire T1 et un transistor IGBT T2 montés en parallèle. Les collecteurs des transistors T2 et T1 sont reliés à une borne A destinée à être reliée à un potentiel haut (ou à une borne d'une charge dont l'autre borne est reliée à un potentiel haut). Les émetteurs des transistors T1 et T2 sont reliés à une borne B par l'intermédiaire d'un dispositif de contrôle du courant 10. La borne B est destinée à être reliée à un potentiel bas (ou à une borne d'une charge dont l'autre borne est reliée à un potentiel bas). La grille du transistor T2 est reliée à une borne C sur laquelle est appliquée une tension de commande de l'interrupteur statique. La borne C est également reliée à la base du transistor T1 à travers un interrupteur électronique S et un amplificateur de courant 12. L'amplificateur 12, lorque la tension de commande est présente à son entrée, fournit un courant de base au transistor T1 saturant celui-ci pour des courants atteignant une valeur maximale choisie I₁. L'interrupteur S est commandé par le dispositif de contrôle 10 qui détermine si le courant I circulant entre les bornes A et B est supérieur à un courant prédéterminé I₀ ajusté à une valeur voisine de la valeur Iₜ mentionnée en relation avec la figure 1.

Le fonctionnement de cet interrupteur statique est le suivant. Dès que l'on applique une tension de commande sur la borne C, le transistor IGBT T2 devient conducteur. Si le courant I s'établit à une valeur inférieure à I₀, le dispositif 10 laisse l'interrupteur S ouvert et le transistor T2 est le seul à conduire. Si le courant I s'établit à une valeur supérieure à I₀, le dispositif 10 ferme l'interrupteur S et le transistor bipolaire T1 devient conducteur. Dès lors, le courant I passe préférentiellement dans le transistor T1 puisque sa chute de tension Vce est plus faible que celle du transistor IGBT T2.

Tel qu'il a été décrit jusqu'ici, l'interrupteur statique selon la présente invention présente les caractéristiques d'un transistor IGBT pour des courants inférieurs à I₀, et les caractéristiques d'un transistor bipolaire pour des courants supérieurs. Par conséquent, cet interrupteur présente la plus faible dissipation de puissance possible pour une plage de courants à commuter comprise entre une valeur faible et un courant maximal pour lequel le transistor bipolaire est encore à la saturation.

En outre, comme on l'a mentionné précédemment, lorsque le courant I croît au-delà de la valeur maximale I₁, le transistor T1 se met à fonctionner en régime linéaire et, comme cela est représenté à la figure 1, la puissance dissipée par ce transistor croît rapidement. Mais, comme la commande de grille du transistor IGBT T2 a été maintenue, la puissance dissipée par le transistor T1 croît jusqu'au moment, correspondant à un courant 13 dans la figure 1, où la tension Vce du transistor T1 atteint la tension Vce du transistor T2. Comme cela est représenté, l'égalité des tensions Vce pour le courant 13 se produit lorsque la puissance dissipée par le transistor T1 est supérieure de la valeur P1₀-P3₀ à la puissance qui serait dissipée par le transistor T2 seul. A partir du courant I₃, l'interrupteur selon la présente invention présente donc une caractéristique parallèle à celle du transistor T2 seul, décalée vers le haut de la valeur P1₀-P3₀. Alors, le courant I passe préférentiellement par le transistor T2 et les pertes sont réduites. On a représenté en trait gras la caractéristique résultante de l'interrupteur de la présente invention entre un courant nul et un courant supérieur à I₃.

Ainsi, pour réaliser un interrupteur statique susceptible de fonctionner normalement entre une valeur basse et une valeur maximale (I₁) et de fonctionner occasionnellement pendant des temps brefs au-delà de cette valeur maximale (I₁), on choisira un interrupteur selon la présente invention pour lequel le circuit de commande de base du transistor bipolaire est dimensionné pour cette valeur maximale. On limite ainsi la dissipation de la commande de base (12) du transistor T1 à une valeur acceptable (P1₀ au lieu de, par exemple, P2₀ pour obtenir la caractéristique de la courbe 2). En effet, comme on vient de l'exposer, il n'est pas nécessaire avec l'interrupteur selon la présente invention de dimensionner la commande de base pour que le transistor T1 soit saturé pour des pics de courant occasionnels supérieurs au courant maximal I₁, car ces pics passent préférentiellement par le transistor IGBT T2 en occasionnant des pertes de puissance moindres que dans le cas où ces pics passeraient par le transistor T1 non saturé.

La figure 3 illustre l'interrupteur statique de la figure 2 associé à des éléments de protection. On a également représenté plus en détail un mode de réalisation du dispositif de contrôle du courant 10 et de l'interrupteur S. La grille du transistor T2 est reliée à la sortie d'une porte ET 20 à deux entrées. L'entrée de l'amplificateur 12 de commande de la base du transistor T1 est reliée à la sortie d'une porte ET 22 à trois entrées. Les premières entrées des portes ET 20 et 22 sont reliées à la borne C sur laquelle est appliquée un signal logique de commande VC ayant pour référence, par exemple, une masse reliée à la borne B. Les deuxièmes entrées des portes ET 20 et 22 sont normalement maintenues à l'état haut par un dispositif de mémorisation 24. Ainsi, lorsqu'on applique un signal de commande VC à l'état haut à la borne C, ce signal est transmis sur la grille du transistor T2 qui devient conducteur. Le transistor T1 ne devient conducteur que si la troisième entrée de la porte ET 22 est mise à l'état haut.

En série entre les transistors et la borne B est disposée une résistance shunt Rs convertissant le courant I en une tension amplifiée par un amplificateur différentiel 26. La tension de sortie de l'amplificateur 26 est comparée à une tension de référence V1 par un comparateur 28 dont la sortie commande la troisième entrée de la porte ET 22. Lorsque la tension de sortie de l'amplificateur 26 est supérieure à la tension V1, la sortie du comparateur 28 passe à l'état haut rendant passante la porte ET 22. La tension V1 sera choisie égale à la tension de sortie de l'amplificateur 26 lorsque la résistance Rs est traversée par le courant I0 précédemment mentionné, qui est de préférence choisi égal à la valeur It.

Les éléments non encore décrits de la figure 3 forment un circuit protecteur des transistors ou de la charge commandée par ces transistors. La tension de sortie de l'amplificateur 26 est comparée à une deuxième tension de référence V2, supérieure à la tension V1, par un comparateur 30. La tension de sortie de l'amplificateur 26 est également appliquée à un filtre passe-bas constitué d'un réseau RC, dont la sortie est comparée à une troisième tension de référence V3, comprise entre les tensions V1 et V2, par un comparateur 32. Les sorties des comparateurs 30 et 32 sont reliées à une porte OU 34 connecté à l'entrée du dispositif de mémorisation 24. Comme précédemment mentionné, la sortie du dispositif 24 est normalement à l'état haut et une impulsion à son entrée provoque le passage à l'état bas de sa sortie. Ainsi, lorsque le courant I dépasse une valeur limite correspondant à la tension V2, la sortie du comparateur 30 bascule à l'état haut, cet état étant transmis à l'entrée du dispositif de mémorisation 24 par la porte OU 34. La sortie du dispositif 24 passe à l'état bas en coupant la commande des transistors T1 et T2. L'état haut de la sortie du dispositif 24 est rétabli par un front descendant du signal de commande VC.

Si le courant I atteint une valeur comprise entre les valeurs correspondant aux tensions V3 et V2, les transistors seront coupés seulement si le courant I se maintient à cette valeur suffisamment longtemps. En effet, la tension de sortie du réseau RC croît progressivement et atteint la valeur V3 après un intervalle de temps qui dépend des valeurs de la résistance R et de la capacité C.

De plus, le dispositif de mémorisation 24 sera prévu pour que, au bout de par exemple deux coupures des transistors T1 et T2, l'état haut de la sortie du dispositif 24 ne soit plus rétabli par un front descendant du signal de commande VC.

L'homme de l'art réalisera facilement le dispositif de mémorisation 24 à l'aide de bascules et de portes logiques selon ses besoins spécifiques.

La figure 4 illustre, à titre d'exemple, un schéma possible d'un tel dispositif de mémorisation 24. Le dispositif comprend une première bascule de type D 41 dont la sortie inversée Q* est reliée à l'entrée de donnée D et dont l'entrée d'horloge est reliée à la sortie de la porte OU 34 fournissant l'état à mémoriser. La sortie Q* est également reliée à l'entrée d'horloge d'une deuxième bascule D 42 dont l'entrée D est reliée à un potentiel d'alimentation haut Vcc. La sortie non inversée Q de la bascule 42 est reliée à une entrée d'une porte NON OU 44 dont la sortie commande la porte ET 22. La tension de commande VC est fournie à une entrée d'une porte ET 46 dont la sortie est reliée à une entrée de remise à zéro inversée R* d'une troisième bascule D 48. La sortie Q de cette bascule 48 est reliée à l'autre entrée de la porte NON OU 44, son entrée D est reliée au potentiel Vcc et son entrée d'horloge est reliée cela sortie de la porte OU 34. Les entrées de remise à zéro R* des autres bascules et l'autre entrée de la porte ET 46 sont reliées au point de connexion entre une résistance 50 reliée au potentiel Vcc et une capacité 51 reliée à la masse. Ce circuit résistance-capacité assure une remise à zéro des bascules à la mise sous tension du dispositif.

De nombreuses variantes et modifications de la présente invention apparaîtront à l'homme de l'art. Par exemple, à la place de chacun des transistors, on peut prévoir plusieurs transistors en parallèle.

## Revendications

1. Interrupteur statique comprenant au moins un transistor bipolaire (T1) dont la base est commandée à travers un amplificateur (12) par un signal de commande (VC) et un capteur (10) mesurant le courant (I) traversant l'interrupteur, caractérisé en ce qu'il comprend :
- au moins un transistor bipolaire à grille isolée (T2), encore appelé IGBT, connecté en parallèle sur ledit au moins un transistor bipolaire (T1), dont la grille est commandée par ledit signal de commande (VC) ; et
- des moyens (S) pour couper la commande de la base dudit au moins un transistor bipolaire (T1) lorsque le courant traversant l'interrupteur est inférieur à une valeur prédéterminée (I₀).

2. Interrupteur statique selon la revendication 1, caractérisé en ce que lesdits moyens (S) sont pilotés par un comparateur (28) comparant le courant traversant l'interrupteur à ladite valeur prédéterminée (I₀).

3. Interrupteur statique selon la revendication 1, caractérisé en ce que ledit amplificateur (12) est prévu pour fournir un courant de base au transistor bipolaire (T1) adapté à le mettre en régime de saturation jusqu'à un courant maximal déterminé (I₁) et en ce que ladite valeur prédéterminée (I₀) est choisie égale au courant (It) pour lequel la puissance dissipée par le transistor bipolaire est égale à la puissance dissipée par le transistor IGBT.

4. Interrupteur statique selon l'une quelconque des revendications 1 à 3, caractérisé en ce qu'il comprend un deuxième comparateur (30) comparant le courant traversant l'interrupteur à une deuxième valeur prédéterminée, associé à des moyens (20, 22) coupant la commande desdits transistors si le courant est supérieur à la deuxième valeur prédéterminée.

5. Interrupteur statique selon l'une quelconque des revendications 1 à 4, caractérisé en ce qu'il comprend un troisième comparateur (32) comparant le courant traversant l'interrupteur à une troisième valeur prédéterminée, associé à des moyens coupant la commande desdits transistors lorsque le courant reste supérieur à la troisième valeur prédéterminée pendant une durée plus longue qu'une durée prédéterminé.

6. Interrupteur statique selon l'une des revendications 4 et 5, caractérisé en ce que des moyens (24) sont prévus pour mémoriser le nombre de coupures consécutives de la commande desdits transistors et pour couper définitivement leur commande si ce nombre est supérieur à un nombre prédéterminé.

## Patentansprüche

1. Statischer Schalter mit mindestens einem Bipolartransistor (T1), dessen Basis durch einen Verstärker (12) durch ein Steuersignal (VC) gesteuert wird und mit einem Sensor (10) zur Messung des durch den Schalter fließenden Stroms (I), dadurch gekennzeichnet, daß folgendes vorgesehen ist:
- mindestens ein Bipolarteransistor (T2) mit isoliertem Gate, der auch als IGBT bezeichnet wird, und zwar parallel geschaltet zu dem mindestens einen Bipolartransistor (T1), wobei dessen Gate durch das Steuersignal (VC) gesteuert wird; und
- Mittel (S) zum Sperren der Basissteuerung des mindestens einen Bipolartransistors (T1) dann, wenn der durch den Schalter fließende Strom kleiner ist als ein vorbestimmter Wert (Iₒ)

2. Statischer Schalter nach Anspruch 1, wobei die Mittel (S) durch einen Komparator (28) gesteuert werden, der den durch den Schalter fließenden Strom mit dem vorbestimmten Wert (Iₒ) vergleicht.

3. Statischer Schalter nach Anspruch 1, wobei der Verstärker (12) betreibbar ist, um einen Basisstrom an den Bipolartransistor (T1) zu liefern, der geeignet ist, den Bipolartransistor bis zu einem vorbestimmten Maximalstrom (I1) zu sättigen, und
wobei der vorbestimmte Wert (Iₒ) derart ausgewählt ist, daß er gleich dem Strom (It) ist, für den die Verlustleistung des Bipolartransistors gleich der Verlustleistung des IGBT ist.

4. Statischer Schalter nach einem der vorhergehenden Ansprüche 1 bis 3, wobei ein zweiter Komparator (30) vorgesehen ist, der den durch den Schalter fließenden Strom mit einem zweiten vorbestimmten Wert assoziiert mit den Mitteln (20, 22) vergleicht und die Steuerung der Transistoren abschaltet, wenn der Strom größer ist als der zweite vorbestimmte Wert.

5. Statischer Schalter nach einem der Ansprüche 1 bis 4, wobei ein dritter Komparator (32) vorgesehen ist, der den durch den Schalter fließenden Strom mit einem dritten vorbestimmten Wert vergleicht, der in Beziehung steht mit Mitteln zum Abschalten der Steuerung der Transistoren, wenn der Strom größer als der dritte vorbestimmte Wert bleibt und zwar während einer Zeitdauer, die länger ist als eine vorbestimmte Zeitdauer.

6. Statischer Schalter nach einem der Ansprüche 4 und 5, wobei Mittel (24) vorgesehen sind zum Speichern der Anzahl von aufeinanderfolgenden Abschaltungen der Steuerung der Transistoren und zum definitiven Abschalten der Steuerung, wenn diese Anzahl größer ist als eine vorbestimmte Anzahl.

## Claims

1. A static switch comprising at least one bipolar transistor (T1), the base of which is controlled through an amplifier 12 by a control signal (VC) and a sensor (10) measuring the current (I) flowing through the switch, characterized in that it comprises:
- at least one insulated gate bipolar transistor (T2), also called IGBT, connected in parallel to said at least one bipolar transistor (T1), the gate of which is controlled by said control signal (VC); and
- means (S) for inhibiting the base control of said at least one bipolar transistor (T1) when the current flowing through the switch is lower than a predetermined value (I₀).

2. A static switch as claimed in claim 1, wherein said means (S) are controlled by a comparator (28) comparing the current flowing through the switch to said predetermined value (I₀).

3. A static switch as claimed in claim 1, wherein said amplifier (12) is operable to provide a base current to the bipolar transistor (T1), which is adapted to saturate the bipolar transistor up to a predetermined maximum current (I1), and wherein said predetermined value (I₀) is selected equal to the current (It) for which the dissipated power in the bipolar transistor is equal to the dissipated power in the IGBT.

4. A static switch as claimed in any of claims 1 to 3, comprising a second comparator (30) comparing the current flowing through the switch to a second predetermined value, associated to means (20, 22), shutting down the control of said transistors if the current is greater than the second predetermined value.

5. A static switch as claimed in any of claims 1 to 4, comprising a third comparator (32) comparing the current flowing through the switch to a third predetermined value, associated to means shutting down the control of said transistors when the current remains greater than the third predetermined value during a time greater than a predetermined time.

6. A static switch as claimed in claim 4 or 5, wherein means (24) are provided for storing the number of consecutive shut downs of the control of said transistors and for definitively shutting down their control if this number is greater than a predetermined number.
